# EUROPEAN PATENT SPECIFICATION

(11) **EP 4 080 552 B1**
(45) Date of publication and mention of the grant of the patent: **09.08.2023**
(21) Application number: 21170245.1
(22) Date of filing: 23.04.2021
(51) Int. Cl.: H01L 21/67, H01L 21/673, H01L 21/683, H01L 21/687

(54) **FRAME SYSTEM FOR HOLDING A SUBSTRATE**
RAHMENSYSTEM ZUM HALTEN EINES SUBSTRATS
SYSTÈME DE CADRE DE FIXATION D'UN SUBSTRAT

(43) Date of publication of application: 26.10.2022
(73) Proprietor: Semsysco GmbH, 5020 Salzburg (AT)
(72) Inventor: TSCHINDERLE, Ulrich, 9500 Villach (AT); ÖTZLINGER, Herbert, 5300 Hallwang (AT); WAGNER, Louis, 83666 Waakirchen (DE)
(74) Representative: Maiwald GmbH

(56) References cited:
- WO-A1-2015/158390
- WO-A1-2018/225826
- JP-A- 2014 080 645

## Description

### TECHNICAL FIELD

The present invention relates to a frame system for holding a substrate during a chemical and/or electrolytic surface treatment of the substrate.

### BACKGROUND

Wet chemical processing of substrates or work pieces is one of the most used technologies in many different industries, especially in the semiconductor related industry, to clean or etch a surface of the substrates. The wet chemical processing allows a high chemical selectivity, which can be achieved with various process liquids (such as acids, bases, oxidizers, etc.) or simple or complex mixtures thereof. In addition, the wet chemical processing allows an inherent simplicity of the processing, scalability of the process to various types of substrates having various sizes and a low cost of operation. An additional advantage of the wet chemical processing is that both sides of a flat substrate surface including the edges and sides, or multiple sides of a substrate having a complex geometry can be processed at the same time. It is also possible to process multiple substrates at the same time. Accordingly, the wet chemical processing is applied for a removal of random surface contamination, for a targeted removal of unwanted parts of material layers for further processing in order to create device patterns on the surfaces of the substrate.

In order to achieve a desired surface quality and processing uniformity, it is essential to provide reliable mounting and holding means of the substrate during and after the wet chemical process such as rinsing and drying process at the end of the wet chemical process. Conventional substrate holding frames or chucks consist of two frame parts, an upper and a lower half-frame and a substrate is arranged between them by means of mechanical force. Some frames are clamped together and others are manually screwed together, especially for large size substrates.
WO 2015/158390 A1 discloses a holder configured to be attached to a carrier body for holding a substrate. The holder comprises a fixed portion, a floating portion and a fixing mechanism. The fixed portion is attached to the carrier body having a fixed position with respect to the carrier body and the floating portion is movable relative to the fixed portion along at least one direction. The fixing mechanism is provided in a fixed position relative to the floating portion and configured to clamp the substrate in the holder.
JP 2014 080645 A discloses a substrate holding device with holders that are provided along an edge of the substrate and hold the substrate by sandwiching the edge of the substrate. The holders are arranged radially and opposed to each other with respect to the center of the substrate, and the substrate is held at each facing portion while the substrate is attracted in the opposite direction.
WO 2018/225826 A1 discloses a substrate guide provided on a carrier frame of a carrier, which holds a substrate substantially vertically so that a surface of the substrate is in a substantially vertical direction. The substrate guide comprises a base, a substrate support and a force-applying member. The substrate support comes into contact with a peripheral edge end surface portion of the substrate held by the carrier and is attached to the base to be movable in a normal direction of the peripheral edge end surface portion in a direction parallel to the surface of the substrate.

### SUMMARY

Hence, there may be a need to provide a reliable mounting and holding means of a substrate, which facilitates securing the substrate, thus increasing a quality of a substrate treatment.

The problem is solved by the subject matter of the independent claim of the present invention, wherein further embodiments are incorporated in the dependent claims.

According to the present disclosure, a frame system is presented. The frame system is configured for holding a substrate during a chemical and/or electrolytic surface treatment of the substrate. The frame system comprises a frame element and several finger units arranged at the frame element. The frame element is configured to at least partially surround lateral edges of the substrate and to spare at least a first surface or a second surface of the substrate to be accessible for the surface treatment. Each finger unit comprises a first finger and a second finger. The first finger is configured to contact the first surface of the substrate and the second finger is configured to contact the second surface of the substrate opposite to the first surface of the substrate. The first finger is movable relative to the frame element to clamp the substrate between the first finger and the second finger.

The frame system according to the present disclosure allows a simple, fast, and reliable loading and unloading of the substrate automatically or manually. The frame system further ensures excellent and stable securing of and electrical contact to the substrate eliminating the risk of a substrate breakage and/or harmful electrostatic charging of the substrate during the treatment. In addition, the frame system permits highly efficient and effective chemical processing on all sides of the substrate by an aerodynamically optimized frame system.

The chemical and/or electrolytic surface treatment of the substrate may be any material deposition, galvanizing coating, chemical or electrochemical etching, anodal oxidation, metal separation process or the like. The frame system may be a substrate holder, at which the substrate may be securely held. The substrate may comprise a conductor plate, a semi-conductor substrate, a film substrate, an essentially plate-shaped, metal or metallized workpiece or the like. The substrate may be mounted to the frame system before the chemical and/or electrolytic surface treatment in a processing system is carried out. Accordingly, the frame system allows a safe and non-damaging transfer of the substrate between the loading/unloading station and the processing system.

The frame system may be immersed into an electrochemical deposition tank containing a process fluid and/or an electrolyte for a current distribution. The frame element may comprise at least one, preferably several frameworks assembled together to form a cavity in their center to receive the substrate. The frame element may comprise a rectangular, circular or polygonal shape and at least partially encompass the substrate. The substrate may be substantially plate-shaped such that the frameworks may be aligned with the lateral edges of the substrate. Accordingly, the first surface and the second surface of the plate-shaped substrate may expose to the electrolyte for the surface treatment.

The finger unit may be manufactured integrally with the frame element or arranged releasably at the frame element. In the latter case, the finger unit may be clamped, screwed or the like in order to separate the finger unit individually from the frame element. The finger units may be arranged along the frame element or frameworks and directed to the cavity. In other words, the finger units may protrude from the frame element in direction to the cavity to hold the lateral edges of the substrate. Still in other words, the finger units may also at least partially surround the substrate. The finger units may be configured to hold the substrate with a minimum required force not to cause a breakage or unwanted mechanical transformation. Each finger unit may comprise a pair of fingers or pins consisting of a first finger and a second finger corresponding to each other.

The frame element may comprise a first side or a first frame member and a second side or a second frame member, wherein the first frame member and the second frame member may be separated from each other. The first side or the first frame member may at least partially surround the first surface of the substrate and the second side or the second frame member may at least partially surround the second surface of the substrate. The first frame member may comprise at least one framework and the second frame member may also comprise at least one framework.

The first fingers of the finger units may be arranged at the first side or the first frame member of the frame element and the second fingers of the finger units may be arranged at the second side or the second frame member of the frame element. Alternatively, the first fingers may be arranged at the second side or the second frame member and the second fingers may be arranged at the first side or the first frame member. Further, the first fingers and the second fingers of the finger units arranged along the frame element may be alternately disposed at the first side or the first frame member and the second side or the second frame member.

The first finger of the finger unit may be movable or displaceable relative to the frame element and the second finger of the finger unit may be fixedly arranged at the frame element. Alternatively, the first finger may be fixedly attached to the frame element and the second finger may be movable relative to the frame element. The term "movable" may be understood so that the fingers may be displaced between a closed position and an open position along the frame element to hold or release the substrate between the first and the second finger. Preferably, the first finger or the movable finger may be mounted rotatably at the frame element to apply a clamping force in the closed position.

In an example, the finger units are made of electrically conductive polymers, electrically conductive ceramics, or metallic materials. The finger units can be also made of electrically nonconductive polymers, electrically nonconductive ceramics, or electrically nonconductive plastic materials.

In an example, the frame element and/or the finger units are made of stainless steel, aluminum or titanium. The frame element and/or the finger units may be also made of a chemically compatible or chemically incompatible material and further coated with a chemical compatible polymer. In an example, the frame element and/or the finger units may be coated with a polymer, perfluoro alkoxy alkanes (PFA), ethylene chlorotrifluoroethylene copolymer (ECTFE), polytetrafluoroethylene (PTFE), ethylene tetrafluoroethylene (ETFE), or fluorinated ethylene propylene (FEP). In an example, the first finger and the second finger may be made of the same material as the frame element or a different material of the frame element.

In an example, the second finger is unmovable. In other words, the second fingers of the finger units are fixedly attached to the frame element and only the first fingers may be movable relative to the frame element and/or the second fingers. Still in other words, the second fingers may be mounted in a fixed position at the frame element and the first finger units may rotate relative to the second fingers to apply clamping force for holding the substrate. During loading the substrate onto the frame element, the second surface of the substrate may be placed onto the second fingers, which may serve as a reference position for the substrate.

In an example, the second finger is movable relative to the frame element. In other words, both the first fingers and the second fingers of the finger units may be movable relative to each other such that they may be opened relative to the frame element, which may receive a substrate between the first and the second fingers. This may be particularly useful if more than one substrate may be mounted to the frame element.

In an example, the several finger units are distributed along the frame element with distances between adjacent finger units. The finger units may be arranged at the frame element, preferably at the lateral frameworks of the frame element, which are arranged parallel relative to an immersing direction of the frame system into the deposition tank. The finger units may be spaced from each other along the frame element. The finger units may face each other relative to a transversal direction of the frame element or they may be arranged offset with respect to one another relative to the transversal direction of the frame element. Accordingly, the finger units may be arranged to optimally and reliably hold the substrate without causing any damages or unwanted mechanical transformation.

In an example, the frame system further comprises an actuation unit configured to move the first finger between an open position for receiving and/or releasing the substrate and a closed position for holding the substrate. The actuation unit may be also configured to move the second finger between an open position for receiving and/or releasing the substrate and a closed position for holding the substrate. The actuation unit may comprise a cylinder mechanism, which actuates a movement of the finger units between the open position and the closed position. The actuation unit may be arranged at the frame element, preferably inside the frame element, more preferably at an upper portion of the frame element, which is not immersed into the deposition tank.

The actuation unit may be connected to a control unit, which operates the cylinder mechanism to induce a movement of the finger units and/or frame element. The control unit may be electrically driven or apply pneumatic force. Accordingly, the loading and/or unloading of the substrate may be fully automated.

In an example, the frame system further comprises a pre-tension unit configured to keep the first finger in a rest position, which is the closed position. The pre-tension unit may be also configured to keep the second finger in a rest position, which is the closed position. The pre-tension unit may comprise a spring element connected on one side to the actuation unit or the cylinder mechanism and on the other side to a guide element coupled with frame element via a gear rack element. The spring element may push or release the guide element with respect to the movement of the cylinder mechanism.

The guide element may comprise a tooth structure at a surface, which is in contact with the gear rack element. Hence, if the cylinder mechanism presses the spring element, the spring element may push the guide element, which rotates the gear rack element. Accordingly, the frame element coupled with the gear rack element may be rotated to open the finger units.

Alternatively, the gear rack element may be attached to a supporting element inserted into the frame element and directly connected to the finger units. Hence, when rotating the gear rack element, the supporting element may be rotated, and the finger units may be opened without any movement of the frame element. A number of teeth of the gear rack element, length of the guide element and/or a cylinder stroke of the cylinder mechanism may result in a controlled rotation of the frame element and/or the finger units, preferably 180° rotation of the frame element and/or the finger units.

If the cylinder mechanism returns to its original position, the spring element may rest and the guide element may be released, which corresponds to the closed position of the finger units. Since the spring element tends to being in a rest or released state, the pre-tension unit may ensure a self-closing of the finger units when the cylinder mechanism is not actuated. Accordingly, the substrate held by the finger units may not escape from the frame element. In summary, the open position of the finger units may be performed by operating the actuation unit or the cylinder mechanism and the closed position of the finger units may be performed by releasing the pre-tension unit.

In an example, the first finger and/or the second finger comprise an elastic fingertip element to contact the substrate. An end surface or a distal position of the first and/or the second finger directly contacting the substrate may comprise an elastomer element. The elastomer material for the fingertip element of the first finger and/or the second finger may be chemically resistant such that the elastic fingertip element may not be adversely affected by the electrolyte or any other chemicals used during the treatment. The clamping forces exerted by the finger unit and transferred to the elastic fingertip element of the first and/or the second fingers may be capable to fixedly and securely hold a large size substrate in the closed position. The contact points of the finger units with the surface of the substrate may be also configured to avoid unwanted etch patterns being created during a material removal process step.

In an example, the fingertip element is made of rubber, ethylene-propylene-diene-monomer (EPDM), fluoroelastomer (FPM/FKM), or perfluoroelastomer (FFKM). Such materials may be capable to reduce or even dampen any mechanical stresses or vibrations, which may transfer to the substrate. Further, such materials may be chemically compatible with the processing environment such that the fingertip elements may not be decomposed during the treatment of the substrate, which may otherwise loosen the holding of the substrate.

In an example, at least one of the finger units comprises an electrically conductive grounding path for an electrical grounding of the substrate. Accordingly, an electrical grounding of the substrate may be ensured at all times, to avoid or at least minimize electrostatic charging of the substrate during the chemical and/or electrolytic surface treatment.

In an example, the finger units, the first finger, the second finger and/or the fingertip are exchangeable. The finger units or any parts of the finger units such as fingertips may be separately manufactured and mounted at the frame element or any remaining portion of the finger units. Accordingly, finger units may be assembled individually and optimally in accordance with any requirements or properties of the substrate or the chemical environment. In an example, each finger unit arranged at the frame element may be differently assembled such that each first and/or second finger unit may comprise a different shape or fingertip element made of different material.

In an example, an outer edge of the frame element is pointed and the outer edge is preferably directed to a bottom of the frame system. The framework arranged at a lower portion of the frame element, which firstly contacts the electrolyte when immersing the frame system into the deposition tank, may be tapered in an outer direction. Accordingly, a high-speed immersion and/or extraction of the frame system into and/or out of the deposition tank may be facilitated and splashing of electrolyte and/or chemicals may be avoided. This may be particularly important in case of a high-speed immersion etching process, which may be required to achieve a high process throughput and the best possible top to bottom etch uniformity. Additionally, the pointed design of the frame element may allow an easy removal of residual droplets of a rinsing fluid during a drying process.

In an example, the frame element and/or the finger units comprise a fluid guiding system configured to guide a fluid away from the substrate, preferably in a direction to the bottom of the frame system. The fluid guiding system may comprise a gas stream unit configured to provide a drying gas, preferably from the upper portion to the lower portion of the frame element such that a rinsing fluid film or droplets may be removed downwards and outside the frame system. Accordingly, the rinsing fluid transported away from the frame system or the substrate may not be in contact with the substrate again. For example, the rinsing fluid may be a deionized water and the drying gas may be air or nitrogen gas. The drying process may be performed with gases at elevated temperatures, for example air heated to 70°C or any other process-optimized temperature.

In an example, the frame element and/or the finger units are hydrophobic or hydrophilic. In other words, the frame element and/or the finger units may be coated with a hydrophobic or a hydrophilic material to facilitate the drying process in order to completely remove any residual droplets.

In an example, the frame element and/or the finger units are designed without an undercut. In other words, the frame element and/or the finger units do not comprise any hidden corners or areas, where chemicals or electrolyte may be collected, or droplets of the rinsing fluid may be retained. Such an aerodynamically optimized geometry of the frame element and/or the finger units may enable an effective and efficient rinsing and drying of the frame system and/or the substrate.

In an example, the frame system further comprises only one or two finger units per 500 mm length of substrate. The frame system may comprise a minimum amount of finger units to contact the substrate surface to secure the substrate in place, particularly for high-speed movements. The minimum number of required finger units may depend on dimensions of the substrate. For example, for a 500 x 550 mm substrate only two finger units may be arranged on each lateral side of the frame element, which is parallel to the immersing direction of the frame system in the deposition tank.

In an example, the frame element further comprises at least one resting unit arranged at a bottom edge of the frame element and configured to support the substrate. The resting unit may comprise a resting surface receiving a lower edge of the substrate. Accordingly, the substrate may be reliably retained in place in a vertical direction. The resting surface may be formed very thin and/or tapered in the direction of the substrate to avoid back splashing of the electrolyte and/or droplets. The resting unit may be formed integrally with the frame element or separately manufactured and releasably attached to the frame element. Further, the resting unit may serve as a reference for an automatic loading and/or unloading of the substrate into and from the frame element.

In an example, the frame system further comprises only one unitary frame element. In other words, the all frameworks and/or the first and second frame members of the frame element may be integrally arranged to form a unitary frame element. Accordingly, loading/unloading of the substrate to the frame system may be facilitated through assembling the frame system.

According to the present disclosure, also a use of the frame system as described above for chemically and/or electrochemically processing a substrate, in particular a large substrate, is presented. The chemically and/or electrochemically processing may apply a High Speed Plating (HSP) technology. In an HSP system, at least one substrate is immersed into a deposition tank containing an electrolyte and chemically and/or electrochemically treated.

It should be noted that the above embodiments may be combined with each other irrespective of the aspect involved.

These and other aspects of the present invention will become apparent from and elucidated with reference to the embodiments described hereinafter.

### BRIEF DESCRIPTION OF DRAWINGS

Exemplary embodiments of the invention will be described in the following with reference to the following drawings.
- Fig. 1A and Fig. 1B: show schematically and exemplarily an embodiment of a frame system according to the present invention.
- Fig. 2: shows schematically and exemplarily an embodiment of a frame system according to the present invention.
- Fig. 3A and Fig. 3B: show schematically and exemplarily an embodiment of a finger unit according to the present invention.
- Fig. 4: shows schematically and exemplarily an embodiment of a frame system according to the present invention.
- Fig. 5A to Fig. 5F: shows schematically and exemplarily embodiments of a finger unit according to the present invention.
- Fig. 6: shows schematically and exemplarily an embodiment of a resting unit according to the present invention.

### DESCRIPTION OF EMBODIMENTS

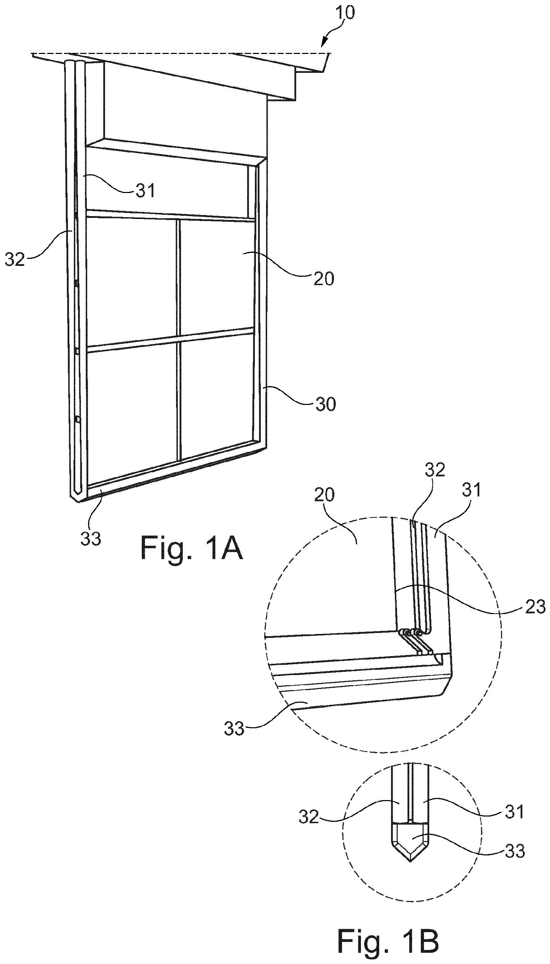

Fig. 1A shows a frame system 10 for holding a substrate 20 during a chemical and/or electrolytic surface treatment of the substrate 20. The substrate 20 may be mounted to the frame system 10 before the treatment is carried out. The frame system 10 allows a simple, fast, and reliable loading and unloading of the substrate 20 automatically or manually.

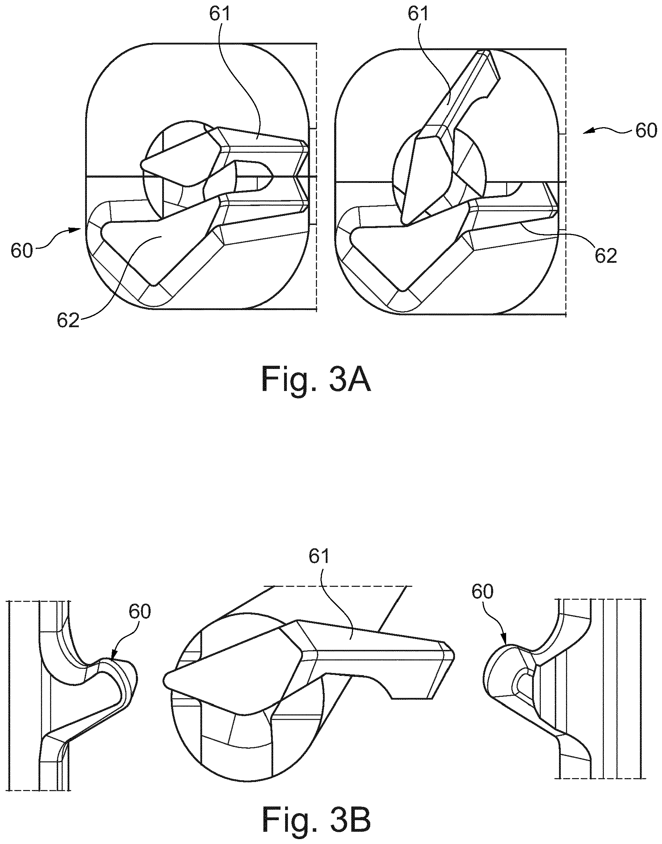

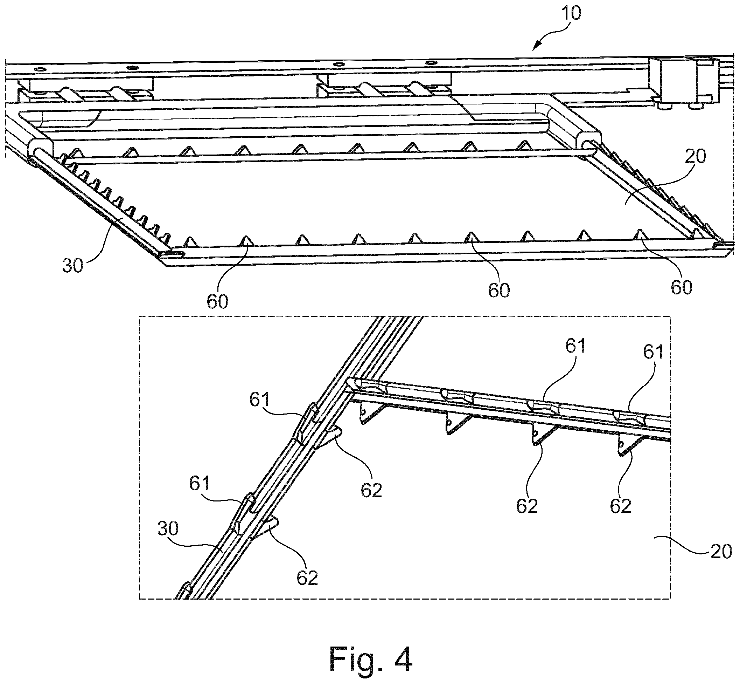

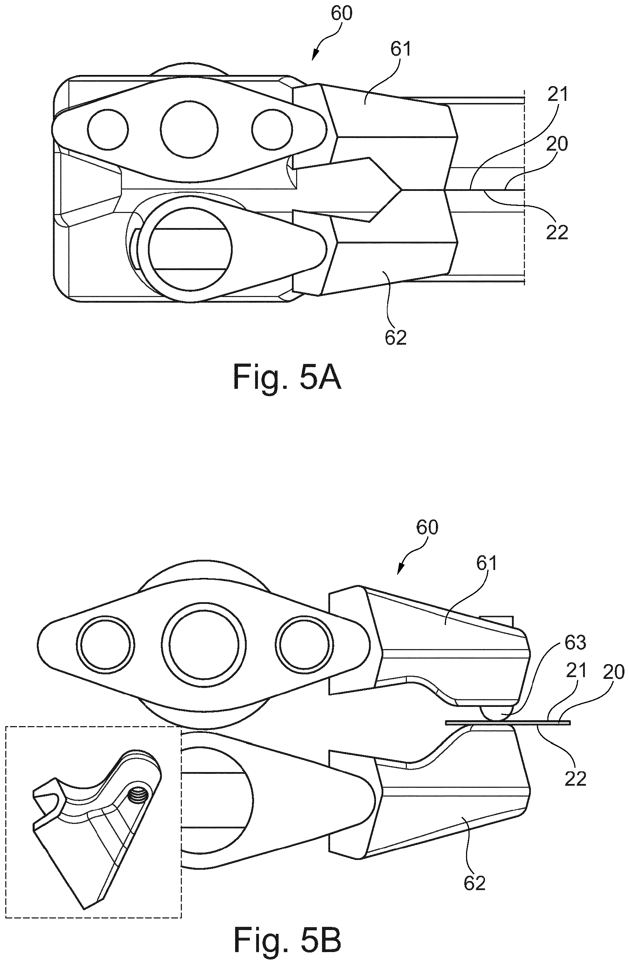

The frame system 10 comprises a frame element 30 and several finger units 60 (see also Fig. 3A, 3B and 4) arranged at the frame element 30. The frame element 30 is configured to at least partially surround lateral edges 23 of the substrate 20 and to spare at least a first surface 21 or a second surface 22 of the substrate 20 to be accessible for the surface treatment (see also Fig. 5A to Fig. 5E). The several finger units 60 are distributed along the frame element 30 with distances between adjacent finger units 60. The frame element 30 may comprise a first frame member 31 and a second frame member 32. The first frame member 31 may at least partially surround the first surface 21 of the substrate 20 and the second frame member 32 may at least partially surround the second surface 22 of the substrate 20.

The frame system 10 may comprise a minimum amount of finger units 60 to contact the substrate surface 21, 22 to secure the substrate 20 in place, particularly for a High Speed Plating (HSP) system. The minimum number of required finger units 60 may depend on the dimensions, weight, as well as on the chemical and physical properties of the substrate material and the surfaces properties of the substrate 20.

The finger units 60 may be manufactured integrally with the frame element 30 or releasably attached to the frame element 30. As shown in Fig. 3A, each finger unit 60 comprises a first finger 61 and a second finger 62. The first finger 61 is configured to contact the first surface 21 of the substrate 20 and the second finger 62 is configured to contact the second surface 22 of the substrate 20 opposite to the first surface 21 of the substrate 20 (see also Fig. 5A to Fig. 5E). Accordingly, the first fingers 61 may be arranged at the first frame member 31 and the second fingers 62 may be arranged at the second frame member 32. The first finger 61 is movable relative to the frame element 30 to clamp the substrate 20 between the first finger 61 and the second finger 62.

The frame element 10 and/or the finger units 60 may be made of stainless steel, aluminum or titanium. The frame element 10 and/or the finger units 60 may be made of a chemically compatible or chemically incompatible material and may be further coated with a chemical compatible polymer.

The frame element 30 and/or the finger units 60 are designed without an undercut (see Fig. 3B). In other words, the frame element 30 and/or the finger units 60 do not comprise any hidden corners or areas, where chemicals or electrolyte may be collected or droplets of the rinsing fluid may be retained.

The frame element 30 further comprises a bottom framework 33 and an outer edge of the bottom framework 33 is pointed (see Fig. 1B). The framework 33 arranged at a lower portion of the frame element 30, which firstly contacts the electrolyte when immersing the frame system 10 into a deposition tank, may be tapered in an outer direction. Accordingly, a high-speed immersion and/or extraction of the frame system 10 into and/or out of the deposition tank may be facilitated and splashing of electrolyte and/or chemicals may be avoided. Additionally, the pointed design of the frame element 30 may allow an easy removal of residual droplets of a rinsing fluid during a drying process.

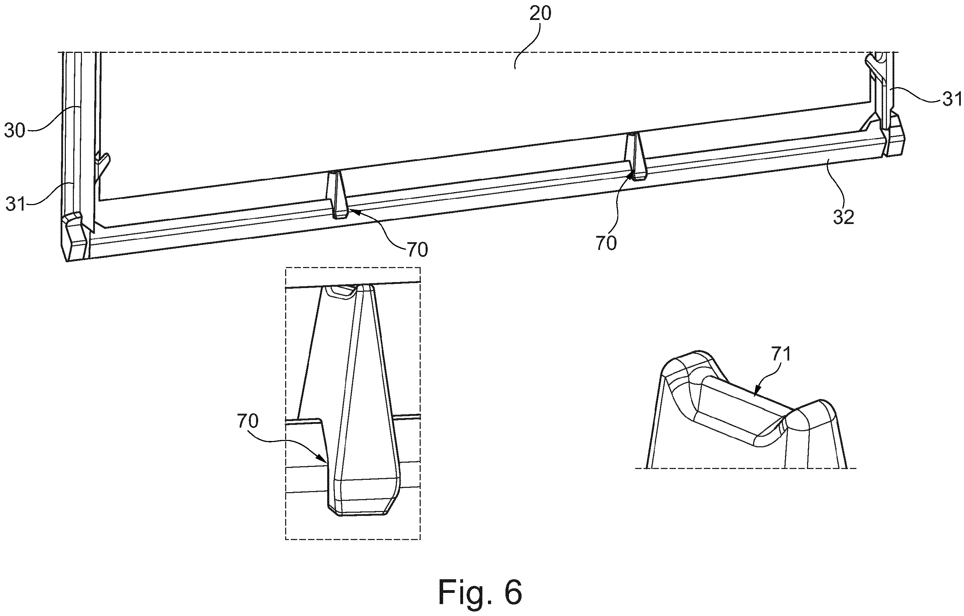

The bottom framework 33 of the frame element 30 comprises at least one resting unit 70, which is configured to support the substrate 20 (see Fig. 6). The resting unit 70 comprise a resting surface 71 receiving a lower edge of the substrate 20. Accordingly, the substrate 20 may be reliably retained in place in a vertical direction. The resting surface 71 is formed very thin and/or tapered in the direction of the substrate 20 to avoid back splashing of the electrolyte.

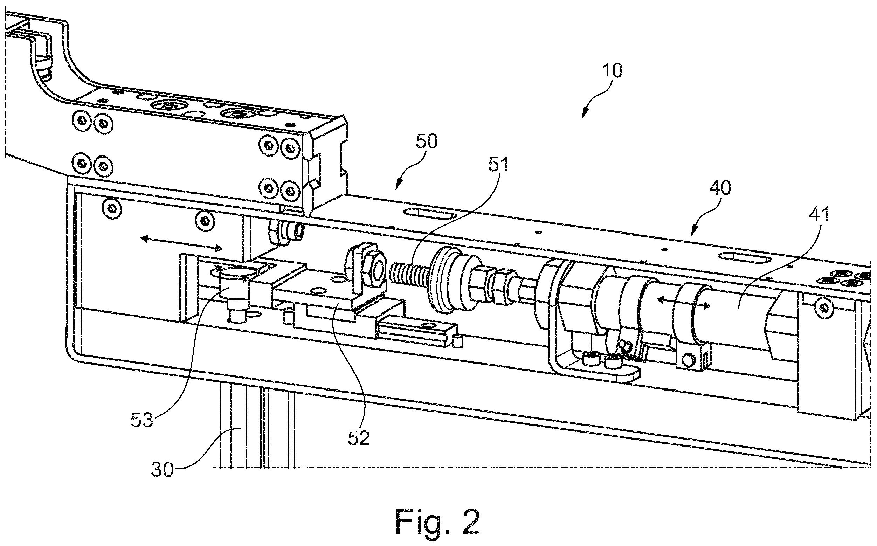

As shown in Fig. 2, the frame system 10 further comprises an actuation unit 40 configured to move movable fingers between an open position for receiving and/or releasing the substrate 20 and a closed position for holding the substrate 20 (see also Fig. 3A and Fig. 4). The actuation unit 40 comprises a cylinder mechanism 41, which actuates a movement of the finger units 60 between the open position and the closed position. The actuation unit 40 is arranged inside the frame element 30, preferably at an upper portion of the frame element 30, which is not immersed into the electrolyte.

Along with opening or closing the finger units 60, the first fingers 61 may be movable between a closed position and an open position to hold or release the substrate 20 between the first finger 61 and the second finger 62, as shown in Fig. 4. Whereas the second fingers 62 are unmovable and fixedly arranged at the frame element 30. During loading the substrate 20 onto the frame system 10, the second surface 22 of the substrate 20 may be placed onto the second fingers 62 and the first fingers 61 may secure the substrate 20 applying clamping force.

The frame system 10 further comprises a pre-tension unit 50 configured to keep the movable first finger 61 in a rest position, which is the closed position. The pre-tension unit 50 comprises a spring element 51 connected on one side to the actuation unit 40 or the cylinder mechanism 41 and on the other side to a guide element 52 coupled with the frame element 30 or the first frame member 31 of the frame element 30. The spring element 51 may push or release the guide element 52 with respect the movement of the cylinder mechanism 41. The guide element 52 comprises a gear rack element 53 coupled with the frame element 30 or the first frame member 31 of the frame element 30.

If the cylinder mechanism 41 presses the spring element 51, the spring element 51 pushes the guide element 52, which rotates the gear rack element 53. The guide element 52 may comprise a tooth structure at a surface, which is in contact with the gear rack element 53. Accordingly, the guide element 52 rotates the gear rack element 53 when the guide element 52 is pressed by the spring element 51, which may lead to a rotation of the frame element 30 or the first frame member 31 of the frame element 30 coupled with the gear rack element 53 to open the finger units 60.

If the cylinder mechanism 41 returns to its original position, the spring element 51 may rest and the guide element 52 may be released, which corresponds to the closed position of the finger units 60. Since the spring element 51 tends to being in a rest or released state, the pre-tension unit 50 may ensure a self-closing of the finger units 60 when the cylinder mechanism is not actuated.

Fig. 5A to Fig. 5F show various embodiments of the finger unit 60. The finger units 60, the first finger 61, the second finger 62 and/or the fingertip 63 are exchangeable. The first finger 61 and the second finger 62 may be symmetrically arranged (see Fig. 5A) or at least one of the first finger 61 and the second finger 62 may comprise an elastic fingertip element 63 made of an elastomer material (see Fig. 5B). Such material may be capable to reduce or even dampen any mechanical stresses or vibrations onto the substrate 20.

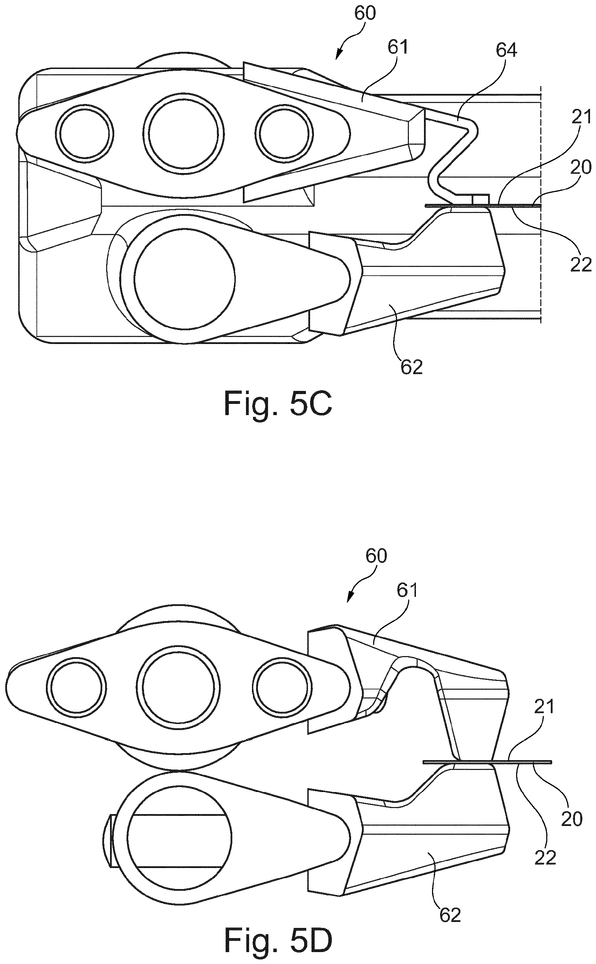

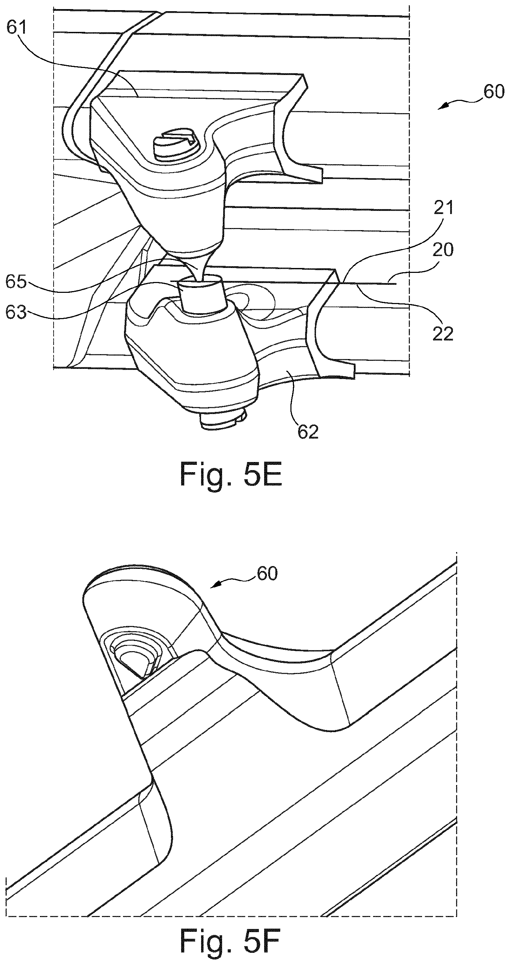

In Fig. 5C the first finger 61 comprises a spring element 64 and in Fig. 5D the first finger 61 comprises a lean finger. As shown in Fig. 5E, the first finger 61 may also comprise a grounding pin 65 to provide an electrically conductive grounding path for an electrical grounding of the substrate 20. In such case, the second finger 62 may comprise an elastic fingertip element 63. However, the first finger 61 can comprise an electrically conductive, elastic fingertip not requiring the second finger 62 to comprise an elastic fingertip. The first finger 61 and/or the second finger 62 may also comprise a dropshaped fingertip element 63 (see Fig. 5F). The various embodiments of the finger unit 60 ensures that the substrate 20 may be reliably held by the frame element without any damage and the treatment of the substrate 20 may be efficiently performed.

The frame system 10 may further comprise a fluid guiding system (not shown) configured to guide a fluid away from the substrate 20, preferably in a direction to the bottom of the frame system 10. The fluid guiding system may comprise a gas stream unit configured to provide a drying gas, preferably from the upper portion to the lower portion of the frame element 30 such that a rinsing fluid film or droplets may be removed downwards and outside the frame system 10.

In the claims, the word "comprising" does not exclude other elements or steps, and the indefinite article "a" or "an" does not exclude a plurality. The invention is defined by the appended set of claims. Various embodiments from the invention may be considered by the skilled person as long as they belong to the scope of said invention which is defined by the appended set of claims.

## Claims

1. A frame system (10) for holding a substrate (20) during a chemical and/or electrolytic surface treatment of the substrate (20), comprising:
- a frame element (30), and
- several finger units arranged at the frame element (30),
wherein the frame element (30) is configured to at least partially surround lateral edges (23) of the substrate (20) and to spare at least a first surface (21) or a second surface (22) of the substrate (20) to be accessible for the surface treatment,
wherein each finger unit (60) comprises a first finger (61) and a second finger (62), wherein the first finger (61) is configured to contact the first surface (21) of the substrate (20) and the second finger (62) is configured to contact the second surface (22) of the substrate (20) opposite to the first surface (21) of the substrate (20),
wherein the first finger (61) is movable relative to the frame element (30) to clamp the substrate (20) between the first finger (61) and the second finger (62),
**characterized in that** the frame system (10) further comprises an actuation unit (40) and a pre-tension unit (50),
wherein the pre-tension unit (50) is coupled with the actuation unit (40) on one side and the frame element (30) on the other side, and
wherein the actuation unit (40) is configured to cause a movement of the pre-tension unit (50) to rotate the frame element (30) to move the first finger (61) between an open position for receiving and/or releasing the substrate (20) and a closed position for holding the substrate (20).

2. Frame system (10) according to claim 1, wherein the second finger (62) is unmovable.

3. Frame system (10) according to claim 1, wherein the second finger (62) is movable relative to the frame element (30).

4. Frame system (10) according to one of the preceding claims, wherein the several finger units (60) are distributed along the frame element (30) with distances between adjacent finger units (60).

5. Frame system (10) according to one of the preceding claims, wherein the pre-tension unit (50) is configured to keep the first finger (61) in a rest position, which is the closed position.

6. Frame system (10) according to one of the preceding claims, wherein the first finger (61) and/or the second finger (62) comprise an elastic fingertip element (63) to contact the substrate (20).

7. Frame system (10) according to one of the preceding claims, wherein at least one of the finger units (60) comprises an electrically conductive grounding path (65) for an electrical grounding of the substrate (20).

8. Frame system (10) according to one of the preceding claims, wherein the finger units (60), the first finger (61), the second finger (62) and/or the fingertip (63) are exchangeable.

9. Frame system (10) according to one of the preceding claims, wherein an outer edge (33) of the frame element (30) is pointed, and wherein the outer edge (33) is preferably directed to a bottom of the frame system (10).

10. Frame system (10) according to one of the preceding claims, wherein the frame element (30) and/or the finger units (60) comprise a fluid guiding system configured to guide a fluid away from the substrate (20), preferably in a direction to the bottom of the frame system (10).

11. Frame system (10) according to one of the preceding claims, wherein the frame element (30) and/or the finger units (60) are designed without an undercut.

12. Frame system (10) according to one of the preceding claims, wherein the frame element (30) and/or the finger units (60) are hydrophobic or hydrophilic.

13. Frame system (10) according to one of the preceding claims, comprising only one or two finger units (60) per 500 mm length of substrate (20).

14. Frame system (10) according to one of the preceding claims, wherein the frame element (30) further comprises at least one resting unit (70) arranged at a bottom edge of the frame element (30) and configured to support the substrate (20).

15. Frame system (10) according to one of the preceding claims, comprising only one unitary frame element (30).

## Patentansprüche

1. Ein Rahmen-System (10) zum Halten eines Substrats (20) während einer chemischen und/oder elektrolytischen Oberflächenbehandlung des Substrats (20), umfassend:
- ein Rahmen-Element (30), und
- mehrere Stift-Einheiten befestigt am Rahmen-Element (30),
wobei das Rahmen-Element (30) ausgelegt ist, wenigstens teilweise seitliche Kanten (23) des Substrats (20) zu umschließen und wenigstens eine erste Oberfläche (21) oder eine zweite Oberfläche (22) des Substrats (20) freizulassen, um für die Oberflächenbehandlung zugänglich zu sein,
wobei jede Stift-Einheit (60) einen ersten Stift (61) und einen zweiten Stift (62) umfasst. wobei der erste Stift (61) ausgelegt ist, die erste Oberfläche (21) des Substrats (20) zu kontaktieren und der zweite Stift (62) ausgelegt ist, die zweite Oberfläche (22) des Substrats (20) entgegen der ersten Oberfläche (21) des Substrats (20) zu kontaktieren,
wobei der erste Stift (61) relativ zum Rahmen-Element (30) beweglich ist, um das Substrat (20) zwischen dem ersten Stift (61) und dem zweiten Stift (62) einzuspannen, **gekennzeichnet dadurch, dass** das Rahmen-System (10) ferner ein Auslösegerät (40) und ein Vorspanngerät (50) umfasst,
wobei das Vorspanngerät (50) mit dem Auslösegerät (40) an einer Seite und dem Rahmen-Element (30) auf der anderen Seite gekoppelt ist, und
wobei das Auslösegerät (40) ausgelegt ist, eine Bewegung des Vorspanngeräts (50) auszulösen, um das Rahmen-Element (30) zu rotieren, um den ersten Stift (61) zwischen einer freien Position zum Aufnehmen und/oder Lösen des Substrats (20) und einer geschlossenen Position für das Halten des Substrats (20) zu bewegen.

2. Rahmen-System (10) nach dem Anspruch 1, wobei der zweite Stift (62) unbeweglich ist.

3. Rahmen-System (10) nach dem Anspruch 1, wobei der zweite Stift (62) relativ zu dem Rahmen-Element (30) beweglich ist.

4. Rahmen-System (10) nach einem der vorhergehenden Ansprüche, wobei die mehreren Stift-Einheiten (60) entlang des Rahmen-Elements (30) mit Abständen zwischen den benachbarten Stift-Einheiten (60) verteilt sind.

5. Rahmen-System (10) nach einem der vorhergehenden Ansprüche, wobei das Vorspanngerät (50) ausgelegt ist, den ersten Stift (61) in einer Ruhelage, welche die geschlossene Position ist, zu halten.

6. Rahmen-System (10) nach einem der vorhergehenden Ansprüche, wobei der erste Stift (61) und/oder der zweite Stift (62) ein elastisches Stiftspitze-Element (63), um das Substrat (20) zu kontaktieren, umfasst.

7. Rahmen-System (10) nach einem der vorhergehenden Ansprüche, wobei wenigstens einer der Stift-Einheiten (60) einen elektrisch-leitenden Erdungsweg (65), für eine elektrische Erdung des Substrats, umfasst.

8. Rahmen-System (10) nach einem der vorhergehenden Ansprüche, wobei die Stift-Einheiten (60), der erste Stift (61), der zweite Stift (62) und/oder die Stiftspitze (63) austauschbar sind.

9. Rahmen-System (10) nach einem der vorhergehenden Ansprüche, wobei eine äußere Kante (33) des Rahmen-Elements (30) spitz zuläuft und wobei die äußere Kante (33) vorzugsweise in Richtung der Unterseite des Rahmen-Systems (10) orientiert ist.

10. Rahmen-System (10) nach einem der vorhergehenden Ansprüche, wobei das Rahmen-Element (30) und/oder die Stift-Einheiten (60) ein Flüssigkeit-Führungssystem umfasst, das ausgelegt ist, die Flüssigkeit von dem Substrat (20) wegzuführen, vorzugsweise in Richtung der Unterseite des Rahmen-Systems (10).

11. Rahmen-System (10) nach einem der vorhergehenden Ansprüche, wobei das Rahmen-Element (30) und/oder die Stift-Einheiten (60) ohne eine Hinterschneidung konstruiert sind.

12. Rahmen-System (10) nach einem der vorhergehenden Ansprüche, wobei das Rahmen-Element (30) und/oder die Stift-Einheiten (60) hydrophob oder hydrophil sind.

13. Rahmen-System (10) nach einem der vorhergehenden Ansprüche, umfassend nur ein oder zwei Stift-Einheiten (60) pro 500 mm Länge des Substrats (20).

14. Rahmen-System (10) nach einem der vorhergehenden Ansprüche, wobei das Rahmen-Element (30) ferner umfasst, dass wenigstens eine Stütz-Einheit (70) an einer Kanten-Unterseite des Rahmen-Elements (30) befestigt und ausgelegt ist, das Substrat (20) zu stützen.

15. Rahmen-System (10) nach einem der vorhergehenden Ansprüche, umfassend nur ein einstückiges Rahmen-Element (30).

## Revendications

1. Système de cadre (10) pour maintenir un substrat (20) pendant un traitement de surface chimique et/ou électrolytique du substrat (20), comprenant :
- un élément formant cadre (30), et
- plusieurs unités de doigts agencées sur l'élément formant cadre (30),
dans lequel l'élément formant cadre (30) est configuré pour entourer au moins partiellement des bords latéraux (23) du substrat (20) et pour épargner au moins une première surface (21) ou une seconde surface (22) du substrat (20) afin qu'elles soient accessibles pour le traitement de surface, dans lequel chaque unité de doigts (60) comprend un premier doigt (61) et un second doigt (62),
dans lequel le premier doigt (61) est configuré pour entrer en contact avec la première surface (21) du substrat (20) et le second doigt (62) est configuré pour entrer en contact avec la seconde surface (22) du substrat (20) opposée à la première surface (21) du substrat (20),
dans lequel le premier doigt (61) est mobile par rapport à l'élément formant cadre (30) pour serrer le substrat (20) entre le premier doigt (61) et le second doigt (62), **caractérisé en ce que** le système de cadre (10) comprend en outre une unité d'actionnement (40) et une unité de pré-tension (50),
dans lequel l'unité de pré-tension (50) est couplée à l'unité d'actionnement (40) d'un côté et à l'élément formant cadre (30) de l'autre côté, et
dans lequel l'unité d'actionnement (40) est configurée pour provoquer un mouvement de l'unité de pré-tension (50) afin de faire tourner l'élément formant cadre (30) pour déplacer le premier doigt (61) entre une position ouverte pour recevoir et/ou libérer le substrat (20) et une position fermée pour maintenir le substrat (20).

2. Système de cadre (10) selon la revendication 1, dans lequel le second doigt (62) est fixe.

3. Système de cadre (10) selon la revendication 1, dans lequel le second doigt (62) est mobile par rapport à l'élément formant cadre (30).

4. Système de cadre (10) selon l'une des revendications précédentes, dans lequel lesdites plusieurs unités de doigts (60) sont réparties le long de l'élément formant cadre (30) avec des distances entre les unités de doigts adjacentes (60).

5. Système de cadre (10) selon l'une des revendications précédentes, dans lequel l'unité de pré-tension (50) est configurée pour maintenir le premier doigt (61) dans une position de repos, qui est la position fermée.

6. Système de cadre (10) selon l'une des revendications précédentes, dans lequel le premier doigt (61) et/ou le second doigt (62) comprennent un élément formant bout de doigt élastique (63) pour entrer en contact avec le substrat (20) .

7. Système de cadre (10) selon l'une des revendications précédentes, dans lequel au moins l'une des unités de doigts (60) comprend un chemin de mise à la terre électriquement conducteur (65) pour une mise à la terre électrique du substrat (20).

8. Système de cadre (10) selon l'une des revendications précédentes, dans lequel les unités de doigts (60), le premier doigt (61), le second doigt (62) et/ou le bout de doigt (63) sont échangeables.

9. Système de cadre (10) selon l'une des revendications précédentes, dans lequel un bord extérieur (33) de l'élément formant cadre (30) est pointu, et dans lequel le bord extérieur (33) est de préférence dirigé vers un fond du système de cadre (10).

10. Système de cadre (10) selon l'une des revendications précédentes, dans lequel l'élément formant cadre (30) et/ou les unités de doigts (60) comprennent un système de guidage de fluide configuré pour guider un fluide à l'écart du substrat (20), de préférence dans une direction allant vers le fond du système de cadre (10).

11. Système de cadre (10) selon l'une des revendications précédentes, dans lequel l'élément formant cadre (30) et/ou les unités de doigts (60) sont conçus sans contredépouille.

12. Système de cadre (10) selon l'une des revendications précédentes, dans lequel l'élément formant cadre (30) et/ou les unités de doigts (60) sont hydrophobes ou hydrophiles.

13. Système de cadre (10) selon l'une des revendications précédentes, comprenant seulement une ou deux unités de doigts (60) par 500 mm de longueur de substrat (20).

14. Système de cadre (10) selon l'une des revendications précédentes, dans lequel l'élément formant cadre (30) comprend en outre au moins une unité de repos (70) agencée sur un bord inférieur de l'élément formant cadre (30) et configurée pour soutenir le substrat (20).

15. Système de cadre (10) selon l'une des revendications précédentes, comprenant un seul élément formant cadre unitaire (30).
